(19) Europäisches Patentamt
European Patent Office
Office européen des brevets

(11) Veröffentlichungsnummer: **0 102 921**
**A2**

# (12) EUROPÄISCHE PATENTANMELDUNG

(21) Anmeldenummer: **83810340.6**

(22) Anmeldetag: **28.07.83**

(51) Int. Cl.³: **G 03 F 7/16**
**G 03 F 7/20**

(30) Priorität: **04.08.82 GB 8222467**

(43) Veröffentlichungstag der Anmeldung:
**14.03.84 Patentblatt 84/11**

(84) Benannte Vertragsstaaten:
**BE CH DE FR GB IT LI NL SE**

(71) Anmelder: **CIBA-GEIGY AG**
**Postfach**
**CH-4002 Basel(CH)**

(72) Erfinder: **Irving, Edward, Dr.**
**41 Swaffham Road**
**Burwell Cambridge CB5 OAN(GB)**

(72) Erfinder: **Smith, Terence James**
**6A Dickasons Melbourn**
**Royston Hertfortshire SG8 6EL(GB)**

## (54) Verfahren zur Erzeugung von Abbildungen aus flüssigen Massen.

(57) Abbildungen werden nach einem Verfahren hergestellt, bei dem man eine auf ein Substrat aufgebrachte Schicht einer(a) ein anärob polymerisierbares Material und (b) ein photopolymerisierbares Material enthaltenden flüssigen Zusammensetzung so lange in einer weitgehend sauerstofffreien Umgebung belässt, dass sich die Zusammensetzung verfestigt. Danach wird sie bildweise mit aktinischer Strahlung belichtet und zur Entfernung der nicht von der Strahlung getroffenen Schichtstellen mit einem Entwickler behandelt.

Als anärob polymerisierbares und photopolymerisierbares Material kann ein Gemisch von zwei oder mehr diese verschiedenen Funktionen aufweisenden Materialien vorliegen, wie ein Acrylatester mit einer Azidoverbindung, oder die beiden Funktionen können in einem einzigen Molekül vereinigt sein. Die Produkte sind zur Herstellung von Druckplatten und gedruckten Schaltungen geeignet.

EP 0 102 921 A2

Croydon Printing Company Ltd

Verfahren zur Erzeugung von Abbildungen aus flüssigen Massen

Vorliegende Erfindung betrifft ein Verfahren zur Erzeugung von Abbildungen aus flüssigen Massen, insbesondere flüssigen Beschichtungen auf Substraten indem diese anäroben Bedingungen und danach aktinischer Strahlung unterworfen werden.

Herkömmlicherweise wird die Erzeugung einer Abbildung mittels Photopolymerisation dadurch erreicht, dass man einen Träger mit einer Lösung einer photopolymerisierbaren Substanz in einem flüchtigen organischen Lösungsmittel beschichtet, das Lösungsmittel abtreibt oder verdunsten lässt, so dass ein Film der photopolymerisierbaren Substanz verbleibt, den Film wie durch eine Vorlage hindurch aktinisch bestrahlt, wodurch die von der Bestrahlung getroffenen Filmstellen photopolymerisiert (und damit weniger löslich) werden, während die von der Strahlung abgeschirmten Stellen im wesentlichen unbeeinflusst bleiben, und dann die unbestrahlten, unphotopolymerisierten Filmstellen mittels eines geeigneten Lösungsmittels, das die bestrahlten, photopolymerisierten Stellen nicht auflöst, entfernt. Diese letzte Stufe ist allgemein als "Entwicklung" bekannt.

Es wäre wünschenswert, ein Verfahren zur Verfügung zu haben, bei dem eine Schicht einer photopolymerisierbaren Substanz auf einen Träger aufgebracht und ohne die Anwendung organischer Lösungsmittel in einen weitgehend festen, nicht klebrigen, bestrahlungsreifen Zustand gebracht werden könnte. Dabei würde man nicht nur die Verwendung von Lösungsmitteln, mit denen Toxizitäts- und Brennbarkeitsprobleme auftreten

sowie Kosten bei ihrer Rückgewinnung entstehen könnten, in dieser Stufe vermeiden, sondern auch die Produktion beschichteter, bestrahlungsreifer Träger auf kontinuierlicher Grundlage erleichtern.

Es wurde nun gefunden, dass man diese Aufgabe durch die Anwendung gewisser Substanzen bzw. Substanzgemische, die sowohl anärobe Härtung als auch Photopolymerisation eingehen können, in flüssiger Form lösen kann. Die Entfernung von Sauerstoff aus einer Schicht solcher Substanzen kann zu Verfestigung führen, ohne deren Fähigkeit, Photopolymerisation einzugehen, zu beeinträchtigen. Gewünschtenfalls kann man gewisse Stellen der Zusammensetzung aktinischer Strahlung aussetzen, wodurch diese Stellen photovernetzt und damit sehr viel widerstandsfähiger gegen Auflösung in Lösungsmitteln werden.

In der U.S. Patentschrift Nr. 4 291 118 ist ein Verfahren zur Erzeugung von Reliefabbildungen aus einem Film flüssigen photopolymerisierbaren Materials beschrieben, welches darin besteht, dass man den Film durch chemische Härtung verfestigt, dann den verfestigten Film mit aktinischer Strahlung in Form eines Musters belichtet bzw. wiederbelichtet, so dass Stellen auf dem Film chemisch differenziert werden, und dann die nicht musterweise mit aktinischer Strahlung belichteten Teile des Films durch Waschen mit einem Lösungsmittel entfernt. Die einzige dabei zur Verfestigung in allen beschriebenen Ausführungsfomen verwendete Methode ist Belichtung mit aktinischer Strahlung, doch enthält die Offenbarung die Bemerkung "Ausserdem ist Wärme ebenfalls anwendbar". Die einzigen erwähnten photopolymerisierbaren Materialen sind Gemische von Polyenen mit Polythiolen. Dieses Verfahren lässt sich nicht leicht erfolgreich durchführen. Erfolgt die anfängliche Verfestigung durch Bestrahlung, so muss man sehr vorsichtig sein, die richtige Menge Strahlung einwirken zu lassen; bei zu wenig Strahlung würde sich die flüssige Zusammensetzung nicht verfestigen und bei zu viel wäre es nicht möglich, nach der zweiten Bestrahlung eine gute Abbildung zu erhalten. Auch läuft die durch Belichtung mit aktinischer Strahlung einge-

leitete Reaktion zwischen dem Polyen und dem Polythiol noch nach Unterbrechung einer solchen Belichtung weiter. Daraus folgt, dass man die bildweise Belichtungsstufe unverzüglich durchführen muss, um Abbildungen guter Qualität zu erhalten. Dies stellt eine weitere Einschränkung der technischen Anwendung des Verfahrens dar.

Anärobe Verfestigung ist zwar seit über 25 Jahren bekannt, doch war die Verwendung anärob polymerisierbarer Materialien, hierin auch als anärob härtbare Materialien bezeichnet, auf Klebverbindungen und Abdichtungen beschränkt.

Zusammensetzungen, die sowohl anärob polymerisierbar als auch photopolymerisierbar sind, wurden in der japanischen Patentoffenlegung 54-22 445 (1979) (Derwent CPI-Referat Nr. 24527B) und der japanischen Patentoffenlegung 55-112 211 (1980) (Derwent CPI-Referat Nr. 72533C) beschrieben. Bei der Verwendung zum Festsetzen von Muttern und Schrauben oder sonstigen Eingriffsteilen bzw. beim Abdichten von Hohlräumen sollen die Zusammensetzungen auf Gegenstände aufgebracht und sowohl anärob als auch durch Lichteinwirkung gehärtet werden, wobei die Bestrahlung mit Licht vor, während oder nach der anäroben Härtung erfolgt. Es wird angegeben, dass bei Durchführung der anäroben Härtung vor der Bestrahlung der einzige nicht anärob gehärtete Teil der Zusammensetzung die Oberfläche ist, welche durch die nachfolgende Bestrahlung gehärtet wird, womit die Bildung der Verbindung oder Abdichtung vervollständigt wird.

Gegenstand dieser Erfindung ist ein Verfahren zur Erzeugung einer Abbildung, welches darin besteht, dass man (1) eine auf ein Substrat aufgebrachte Schicht einer (a) ein anärob polymerisierbares Material und (b) ein photopolymerisierbares Material enthaltenden flüssigen Zusammensetzung so lange in einer weitgehend sauerstofffreien Umgebung belässt, dass sich diese flüssige Zusammensetzung verfestigt,
(2) diese verfestigte Schicht bildweise mit aktinischer Strahlung belichtet und
(3) die Schicht zur Entfernung der bei (2) nicht mit aktinischer Strahlung belichteten Schichtstellen mit einem Entwickler behandelt.

Der Ausdruck "bildweise belichten" umfasst sowohl Belichtung durch eine bildtragende, aus undurchsichtigen und durchsichtigen Stellen bestehende Transparentvorlage hindurch als auch Behandlung mit einem in einem vorbestimmten Muster, beispielsweise unter Rechnerkontrolle, bewegten Laserstrahl zur Erzeugung einer Abbildung.

Die erfindungsgemäss verwendeten, härtbaren flüssigen Zusammensetzungen können aus einem Gemisch einer oder mehrerer anärob härtbarer Substanzen mit einer oder mehreren ausschliesslich photopolymerisierbaren Substanzen bestehen. Sie können aber auch eine oder mehrere "doppelfunktionelle" Substanzen enthalten, d.h. Substanzen, die sowohl anärob härtbar als auch photopolymerisierbar sind, insbesondere Substanzen mit einer oder mehreren anärob härtbaren Gruppen sowie einer oder mehreren ausschliesslich photopolymerisierbaren Gruppen im gleichen Molekül; bei dieser Ausführungsform sind die Materialien (a) und (b) die gleichen. Als weitere Alternative kann die flüssige Zusammensetzung ein Gemisch einer oder mehrerer solcher doppelfunktioneller Substanzen mit einer oder mehreren anärob härtbaren und/oder einer oder mehreren ausschliesslich photopolymerisierbaren Substanzen enthalten.

Anärob polymerisierbare Materialien sind wohlbekannt und zum grossen Teil handelsüblich. Die erfindungsgemäss verwendbaren, anärob polymerisierbaren Materialien bestehen im allgemeinen aus (i) einem gegebenenfalls freie saure oder Aminogruppen enthaltenden Acrylsäureester (ii) einem Polymerisationsinitiator für (i) sowie gewünschtenfalls (iii) einem Beschleuniger für die Polymerisation von (i).

Als Acrylsäureester (i) eignen sich unter anderem Ester, insbesondere Acrylate und Methacrylate, von einwertigen Alkoholen, mehrwertigen Alkoholen (Voll- und Partialester), Hydroxycarbonsäuren, Hydroxysulfonsäuren und Hydroxyphosphorsäuren sowie von Hydroxyalkylaminen und Hydroxyalkylnitrilen und auch Acrylester-urethanen und -ureiden. Die meisten solchen Ester sind im Handel erhältlich und solche, bei denen

dies nicht zutrifft, können nach bekannten Veresterungsmethoden hergestellt werden.

Geeignete Acrylsäureester sind unter anderem solche der Formel

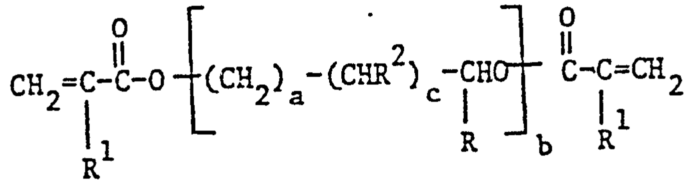

I

worin a eine ganze Zahl von 1 bis 8, b eine ganze Zahl von 1 bis 20 und c null oder 1 ist und R für -H, $-CH_3$, $-C_2H_5$, $-CH_2OH$ oder 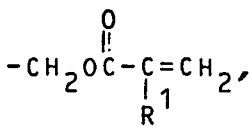, $R^1$ für -H, -Cl, $-CH_3$ oder $-C_2H_5$ und $R^2$ für -H, -OH oder 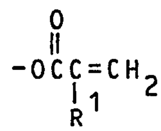 stehen.

Unter solchen Verbindungen werden diejenigen der Formel I bevorzugt, worin a 1 bis 4 und b 1 bis 5 ist und $R^1$ für -H oder $-CH_3$ steht. Verbindungen der Formel I mit b = 2 oder grösser sind in der U.S. Patentschrift Nr. 2 895 950 beschrieben.

Weitere geeignete Ester entsprechen der Formel

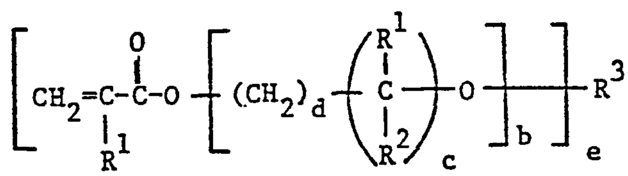

II

worin b, c, $R^1$ und $R^2$ die oben angegebenen Bedeutungen haben, d null oder eine positive ganze Zahl ist, vorausgesetzt dass c und d nicht beide null sind, e 1, 2, 3 oder 4 ist und $R^3$ für einen organischen Rest der Wertigkeit e steht, der über eines bzw. mehrere seiner Kohlenstoffatome an die angegebenen b Sauerstoffatome gebunden ist.

Unter solchen Verbindungen werden diejenigen bevorzugt, worin in der Formel II b, c und d je 1 sind und $R^1$ für -H oder $-CH_3$ sowie $R^3$ für den Kohlenwasserstoffrest eines aliphatischen Alkohols mit 1 bis 6 Kohlenstoffatomen wie $-CH_3$ oder

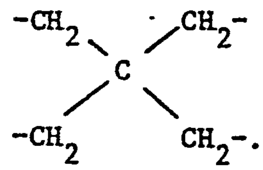

stehen.

Verbindungen der Formel II sind in der britischen Patentschrift Nr. 1 228 479 beschrieben.

Noch weitere geeignete Ester entsprechen der Formel

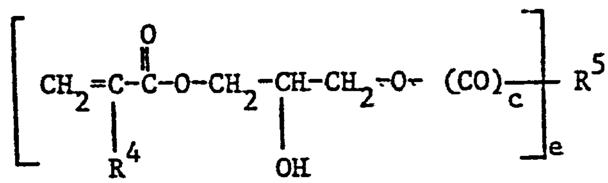

III

worin c und e die oben angegebenen Bedeutungen haben und $R^4$ für -H oder $-CH_3$ sowie $R^5$ für einen organischen Rest der Wertigkeit e stehen, der über eines seiner Kohlenstoffatome gebunden ist, aber nicht das Kohlenstoffatom einer Carbonylgruppe.

Bei c gleich null kann $R^5$ insbesondere den Rest eines Alkohols oder Phenols mit e Hydroxylgruppen und 1 bis 18 Kohlenstoffatomen bedeuten.

Somit kann $R^5$

eine aromatische, araliphatische, alkaromatische, cycloaliphatische, heterocyclische oder heterocyclisch-aliphatische Gruppe, wie eine nur einen Benzolring enthaltende, gegebenenfalls durch Chlor oder Alkylgruppen mit jeweils 1 bis 9 Kohlenstoffatomen substituierte aromatische Gruppe, oder eine gegebenenfalls durch Aethersauerstoffatome unterbrochene, eine Kette von 2 bis 4 Benzolringen enthaltende aromatische Gruppe, aliphatische Kohlenwasserstoffgruppen mit 1 bis 4 Kohlenstoffatomen oder Sulfongruppen, wobei die Benzolringe jeweils gegebenenfalls durch Chlor oder Alkylgruppen mit jeweils 1 bis 9 Kohlenstoffatomen substituiert sind,

oder vorzugsweise eine gesättigte oder ungesättigte, geradkettige oder verzweigte aliphatische Gruppe, die gegebenenfalls Aethersauerstoffbindungen enthalten und durch Hydroxyl-

gruppen substituiert sein kann, insbesondere eine gesättigte oder äthylenisch einfach ungesättigte geradkettige aliphatische Kohlenwasserstoffgruppe mit 1 bis 8 Kohlenstoffatomen darstellen.

Spezielle Beispiele für solche Gruppen sind aromatische Gruppen der Formeln $-C_6H_5$ und $-C_6H_4CH_3$, wobei e dann 1 ist, $-C_6H_4C(CH_3)_2C_6H_4-$ und $-C_6H_4CH_2C_6H_4-$, wobei e dann 2 ist, und $-C_6H_4(CH_2\overset{|}{C}_6H_3-)_f—CH_2C_6H_4-$ mit f = 1 oder 2, wobei e dann 3 oder 4 ist, und aliphatische Gruppen der Formel $-CH_2\overset{|}{C}HCH_2-$ oder $-CH_2\overset{|}{C}H(CH_2)_3CH_2-$, wobei e dann 3 ist, der Formel $-(CH_2)_4-$, $-CH_2CH{=}CHCH_2-$, $-CH_2CH_2OCH_2CH_2-$ oder $-(CH_2CH_2O)_2CH_2CH_2-$, wobei e dann 2 ist, oder der Formel $-(CH_2)_3CH_3$, $-(CH_2)_4OH$, $-CH_2CH{=}CH_2$ oder $-CH_2CH{=}CHCH_2OH$, wobei e dann 1 ist.

Ist c 1, so kann $R^5$ den Rest einer Säure mit e Carboxylgruppen und 1 bis 60 Kohlenstoffatomen darstellen, vorzugsweise

eine gesättigte oder äthylenisch ungesättigte, geradkettige oder verzweigte aliphatische Kohlenwasserstoffgruppe mit 1 bis 20 Kohlenstoffatomen, die gegebenenfalls durch Chloratome substituiert und durch Aethersauerstoffatome und/oder Carbonyloxygruppen (-COO-) unterbrochen sein kann, oder

eine gesättigte oder äthylenisch ungesättigte cycloaliphatische oder aliphatisch-cycloaliphatische, gegebenenfalls durch Chloratome substituierte Kohlenwasserstoffgruppe mit mindestens 4 Kohlenstoffatomen oder

eine gegegenenfalls durch Chloratome substituierte aromatische Kohlenwasserstoffgruppe mit 6 bis 12 Kohlenstoffatomen.

Weiterhin werden solche Verbindungen bevorzugt, in denen $R^5$

eine gesättigte oder äthylenisch ungesättigte, geradkettige oder verzweigte, gegebenenfalls durch eine Hydroxylgruppe substituierte aliphatische Kohlenwasserstoffgruppe mit 1 bis 8 Kohlenstoffatomen,

eine gesättigte oder äthylenisch ungesättigte, geradkettige oder verzweigte, durch Carbonyloxygruppen in der Kette unterbrochene aliphatische Kohlenwasserstoffgruppe mit 4 bis 50 Kohlenstoffatomen,

eine gesättigte oder äthylenisch ungesättigte, monocyclische oder bicyclische cycloaliphatische Kohlenwasserstoffgruppe mit 6 bis 8 Kohlenstoffatomen, eine äthylenisch ungesättigte cycloaliphatisch-aliphatische Kohlenwasserstoffgruppe mit 10 bis 51 Kohlenstoffatomen oder eine einkernige aromatische Kohlenwasserstoffgruppe mit 6 bis 8 Kohlenstoffatomen darstellt.

Spezielle Beispiele für diese Carbonsäurereste sind solche der Formel $-CH_3$, $-CH_2CH_3$, $-CH_2CH(OH)CH_3$, $-CH_2Cl$ und $-C_6H_5$, wobei e dann 1 ist, sowie $-CH_2CH_2-$, $-CH=CH-$ und $-C_6H_4-$, wobei e dann 2 ist.

Verbindungen der allgemeinen Formel III sind in den britischen Patentschriften Nr. 989 201, 1 006 587, 1 235 769 und 1 241 851 und in den U.S. Patentschriften Nr. 3 221 043, 3 549 583, 3 632 854, 3 642 739, 3 657 117 und 3 697 619 beschrieben.

Als Ester eignen sich weiterhin auch Acrylat-urethane und Acrylat-ureide der Formel

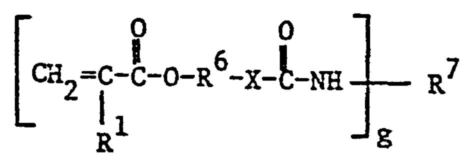

IV

worin $R^1$ die oben angegebene Bedeutung hat, $R^6$ für eine zweiwertige aliphatische, cycloaliphatische, aromatische oder araliphatische, über eines oder mehrere ihrer Kohlenstoffatome an das angegebene -O-Atom bzw. -X-Atom oder -gruppe gebundene Gruppe und X für -O-, -NH- oder -N(alkyl)-, worin der Alkylrest 1 bis 8 Kohlenstoffatome aufweist, stehen, g eine ganze Zahl von mindestens 2 und höchstens 6 ist . sowie $R^7$ eine g-wertige cycloaliphatische, aromatische oder araliphatische, über eines oder mehrere ihrer Kohlenstoffatome an die angegebenen NH-Gruppen gebundene Gruppe bedeutet.

Vorzugsweise steht $R^6$ für eine zweiwertige aliphatische Gruppe mit 2 bis 6 Kohlenstoffatomen und $R^7$ für eine der folgenden: eine zweiwertige aliphatische Gruppe mit 2 bis 10 Kohlenstoffatomen, wie eine Gruppe der Formel $-(CH_2)_6-$, $-CH_2C(CH_3)_2CH_2CH(CH_3)(CH_2)_2-$ oder

$-CH_2CH(CH_3)CH_2C(CH_3)_2(CH_2)_2$; eine gegebenenfalls durch eine Methylgruppe oder ein Chloratom substituierte Phenylengruppe; eine Naphthylengruppe; eine Gruppe der Formel

$$-C_6H_4C_6H_4-,\ -C_6H_4CH_2C_6H_4-\ \text{oder}\ -C_6H_4C(CH_3)_2C_6H_4-$$

oder eine einkernige Alkylcycloalkylen- oder Alkylcycloalkylalkylengruppe mit 6 bis 10 Kohlenstoffatomen, wie eine Methylcyclohex-2,4-ylen, Methylcyclohex-2,6-ylen- oder 1,3,3-Trimethylcyclohex-5-ylenmethylgruppe.

Verbindungen der allgemeinen Formel IV sind in der U.S. Patentschrift Nr. 3 425 988 beschrieben.

Noch weitere geeignete Acrylate sind solche der Formel

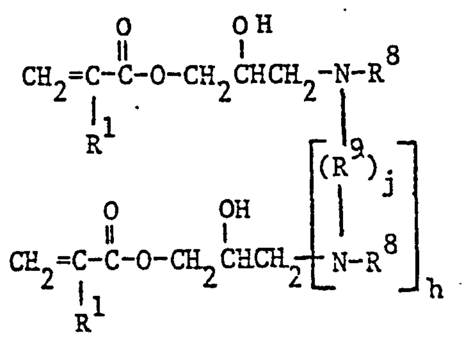

V

worin $R^1$ jeweils die oben angegebene Bedeutung hat, $R^8$ jeweils für -H oder einen gegebenenfalls durch eine Cyan- oder Hydroxylgruppe oder eine Gruppe der Formel

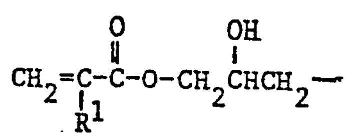

substituierten Alkylrest mit 1 bis 6 Kohlenstoffatomen und $R^9$ für einen zweiwertigen aliphatischen, aromatischen, heterocyclischen oder cycloaliphatischen, über seine Kohlenstoffatome an die angegebenen Stickstoffatome gebundenen Rest mit 1 bis 10 Kohlenstoffatomen stehen, h null oder eine ganze Zahl von 1 bis 3, aber nicht kleiner als j ist und j null oder 1 ist, und zwar 1, wenn h 2 oder 3 ist.

$R^8$ bedeutet vorzugsweise eine Isopropylgruppe und $R^9$ vorzugsweise eine Aethylen-, Propylen- oder p-Phenylengruppe.

Ein spezielles Beispiel für eine Verbindung der all-

gemeinen Formel V ist die Verbindung der Formel

$$\left[CH_2{=}CHCOOCH_2\overset{\overset{OH}{|}}{C}HCH_2\right]_2 NCH(CH_3)_2 \qquad VI$$

Verbindungen der allgemeinen Formel V sind in der britischen Patentschrift Nr. 1 339 017 beschrieben.

Typische, als (i) verwendbare polyfunktionelle Acrylester sind die Acrylate und Methacrylate von Aethylenglykol, Butan-1,4-diol, Neopentylglykol, Diäthylenglykol, Dipropylenglykol, Triäthylenglykol, Tripropylenglykol, Trimethylolpropan, Pentaerythrit, 1,4-Bis-(2-hydroxy-3-methacryloyloxypropoxy)-butan, Poly-(2-hydroxy-3-(methacryloyloxy)-propyl)-äthern von Bisphenolen und Phenol/Formaldehydnovolaken, 2,4-Bis-(2-methacryloyloxyäthoxycarbonamido)-toluol und 2,6-Bis-(2-methacryloyloxyäthoxycarbonamido)-toluol.

Solche Ester (i) werden bevorzugt, die nur eine Acrylester-, insbesondere Acrylat- oder Methacrylatgruppe pro Molekül enthalten. Dazu gehören Acrylat- und Methacrylatester gesättigter oder ungesättigter einwertiger Alkohole, welche aliphatische Alkohole wie 2-Methoxyäthanol oder Allylalkohol, cycloaliphatische Alkohole wie Cyclohexanol oder Dicyclopentenylalkohol, heterocyclische aliphatische Alkohole wie Furfurylalkohol oder Tetrahydrofurfurylalkohol oder araliphatische Alkohole wie Benzylalkohol sein können. Ferner gehören dazu Ester der Formel III mit e = 1, zum Beispiel 2-Hydroxy-3-methacryloyloxypropoxybenzol und 2-Hydroxy-3-acryloyloxypropoxybenzol sowie Partialester mehrwertiger Alkohole, die durch Veresterung des Alkohols oder durch Umsetzung eines 1,2-Alkylenoxyds mit Acryl- oder Methacrylsäure herstellbar sind, z.B. Polyäthylenglykol-monomethacrylat mit 5 bis 20 Aethylenoxydeinheiten, Polypropylenglykol-monomethacrylat mit 5 oder 6 Propylenoxydeinheiten, 2-Hydroxyäthylmethacrylat und 2-Hydroxypropylacrylat. Weitere geeignete Ester sind solche mehrwertiger Alkohole, bei denen eine alkoholische Hydroxylgruppe durch eine Acryloyloxy- oder Methacry-

loyloxygruppe und die verbleibende(n) alkoholische(n) Hydroxylgruppe bzw. -gruppen durch andere Acyloxygruppen substituiert sind, wobei es sich um Metallchelat bildende Gruppen handeln kann, beispielsweise Acetoacetoxyäthylmethacrylat. Weitere geeignete Ester sind die Acrylate und Methacrylate von Hydroxycarbonsäuren wie Glykolsäure oder dimerisierter Hydracrylsäure (3-Hydroxypropionsäure), Hydroxysulfonsäuren wie 2-Hydroxyäthansulfonsäure, Hydroxyphosphorsäuren wie 2-Hydroxyäthyl-dihydrogenphosphat, Hydroxyalkylaminen wie 2-(Diäthylamino)-äthanol und Hydroxyalkylnitrilen wie 2-Cyanäthanol sowie Ester-urethanen wie 2-Methacryloyloxyäthoxycarbonamidobenzol.

Erfindungsgemäss verwendbare Polymerisationsinitiatoren oder -katalysatoren sind unter anderem Hydroperoxyde, Peroxyde, α-Hydroxysulfone, aromatische α-Aminosulfone und Gemische eines organischen Aminoxyds mit einer HN=sauren Verbindung wie einem Sulfon- oder Carbonsäurehydrazid, Sulfimid, Disulfonylimid oder Acylcyanamid. Hydroperoxyde, Peroxyde und Gemische eines Aminoxyds mit einem Sulfonsäurehydrazid werden als Polymerisationsinitiatoren bevorzugt. Verwendbare organische Hydroperoxyde sind unter anderem solche der Formel $R^{10}OOH$, worin $R^{10}$ für einen einwertigen organischen Rest mit bis zu 18 Kohlenstoffatomen, insbesondere einen Alkyl-, Aryl- oder Aralkylrest mit 4 bis 13 Kohlenstoffatomen steht. Typische Hydroperoxyde sind Aethylmethylketonhydroperoxyd, tert.-Butylhydroperoxyd, Cumolhydroperoxyd und durch Oxydation von Ceten oder Cyclohexen gebildete Hydroperoxyde, wobei tert.-Butylhydroperoxyd und Cumolhydroperoxyd besonders wirksam sind. Wasserstoffperoxyd ist ebenfalls verwendbar. Man kann eine Reihe organischer Peroxyde einsetzen, wie 2,5-Dimethyl-2,5-di-(tert.-butylperoxy)-hexan, Di-tert.-butylperoxyd, Dihexylenglykolperoxyd, tert.-Butylcumylperoxyd, Isobutylmethylketonperoxyd sowie Perester, wie tert.-Butylperacetat, tert.-Butylperbenzoat und tert.-Butylperphthalat. Bevorzugte Aminoxyde, die auch in Form ihrer Salze eingesetzt werden können, sind die Oxyde aromatischer tertiärer Amine wie N,N-Dimethyl-p-toluidin und N,N-Dimethyl-

anilin. Als Hydrazide werden solche aromatischer Sulfonsäuren wie Benzolsulfonsäure und p-Toluolsulfonsäure bevorzugt.

Zu geeigneten Beschleunigern (iii) gehören aliphatische Amine mit mindestens 2 primären aliphatischen Aminogruppen und deren Ketimine, wie Diäthylentriamin oder Triäthylentetramin und deren Ketimine mit Isobutylmethylketon; Polyisocyanate wie Toluylen-2,4-diisocyanat; Aldimine, tertiäre Amine wie N,N-Dimethylbenzylamin und Triäthylamin; Imide und Sulfimide wie o-Benzoesäuresulfimid; Dithiocarbamate; Amide und Thioamide wie Formamid; Thiazole wie 2-Mercaptobenzthiazol; Ascorbinsäure; organische Phosphite; quartäre Ammoniumsalze und -basen; Uebergangsmetallsalze; Thioharnstoffe; sowie Polymercaptane, insbesondere Ester von Mercaptancarbonsäuren, wie Glycerin-tris-thioglykolat. Bei einer besonders bevorzugten Ausführungsform ist der Beschleuniger ein Gemisch eines Sulfimids wie o-Benzoesäuresulfimid mit einem aromatischen tertiären Amin wie N,N-Dimethyl-p-toluidin.

Die Menge an Polymerisationsinitiator (ii) kann zwischen 0,01 und 15 Gew.-% auf Ester (i) schwanken, wobei im allgemeinen Mengen von 1 bis 10 Gew.-% eingesetzt werden. Die angewandte Menge Beschleuniger (iii) liegt ebenfalls vorzugsweise zwischen 1 und 10 Gew.-% auf Ester (i).

Erfindungsgemäss verwendbare, ausschliesslich photopolymerisierbare Materialien (b) können solche sein, bei denen Polymerisation durch direkte Aktivierung lichtempfindlicher Gruppen mittels Strahlung erfolgt, oder solche, bei denen die Strahlung ein geeignetes Photoinitiatormolekül aktiviert, welches dann polymerisierbare Gruppen aktiviert.

Materialien mit lichtempfindlichen Gruppen sind wohlbekannt und schliessen solche ein, die mindestens zwei und vorzugsweise drei oder mehr Azido-, Cumarin-, Stilben-, Maleinimido-, Pyridinon-, Chalkon-, Propenon-, Pentadienon- oder in 3-Stellung durch eine äthylenisch oder aromatisch ungesättigte, mit ihren Aethylendoppelbindungen konjugierte Gruppe substituierte Acrylsäuregruppen enthalten.

Materialien, bei denen Photopolymerisation durch Aktivierung eines Photoinitiators erfolgt, der dann polymerisierbare Gruppen aktiviert, sind unter anderem Epoxidharze, Phenolharze, Harnstoff/Formaldehydharze, cyclische Aether, cyclische Ester, cyclische Sulfide, cyclische Amine sowie cyclische Organosiliciumverbindungen zusammen mit einem strahlungsempfindlichen aromatischen Oniumsalz, wie Diazonium-, Sulfonium-, Jodonium- und Sulfoxoniumsalzen.

Geeignete Azide sind beispielsweise solche, die mindestens zwei Gruppen der Formel

$N_3Ar-$ VII

enthalten, worin Ar einen einkernigen oder zweikernigen, zweiwertigen aromatischen Rest mit insgesamt 6 bis höchstens 14 Kohlenstoffatomen, insbesondere eine Phenylen- oder Naphthylengruppe, darstellt.

Als Cumarine eignen sich beispielsweise solche, die Gruppen der Formel

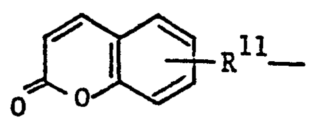

VIII

enthalten, worin $R^{11}$ für ein Sauerstoffatom, eine Carbonyloxygruppe (-COO-), eine Sulfonylgruppe oder eine Sulfonyloxygruppe steht.

Beispiele für Stilbengruppen enthaltende Verbindungen sind solche, die Gruppen der Formel

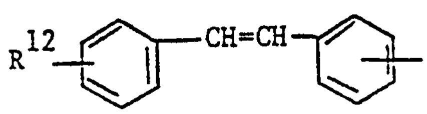

IX

enthalten, worin $R^{12}$ den bis insgesamt 8 Kohlenstoffatome aufweisenden Rest eines 5- oder 6-gliedrigen stickstoffhaltigen heterocyclischen Rings bedeutet, der mit einem Benzol- oder Naphthalinkern kondensiert und über ein Kohlenstoffatom dieses heterocyclischen Rings neben einem seiner Stickstoffheteroatome an den angegebenen Benzolkern gebunden ist, wie ein Benzimidazolyl-, Benzoxazolyl-, Benztriazolyl-, Benzthiazolyl- oder Naphthotriazolylrest.

Beispiele für Maleinimideinheiten enthaltende Verbindungen sind solche mit Gruppen der Formel

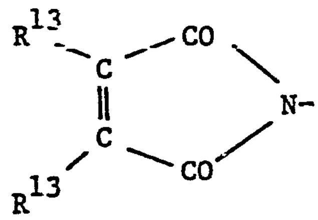

X

worin $R^{13}$ jeweils für eine Alkylgruppe mit 1 bis 4 Kohlenstoffatomen, ein Chloratom oder eine Phenylgruppe, und insbesondere eine Methylgruppe, steht.

Verbindungen mit Pyridinoneinheiten sind beispielsweise solche mit Gruppen der Formel

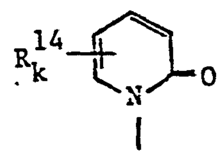

XI

worin $R^{14}$ einen aliphatischen oder cycloaliphatischen Rest mit 1 bis 8 Kohlenstoffatomen bedeutet und $k$ null oder eine ganze Zahl von 1 bis 4 ist.

Beispiele für Chalkon-, Propenon- und Pentadienongruppen enthaltende Verbindungen sind solche mit Gruppen der Formel

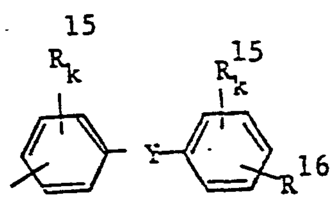

oder

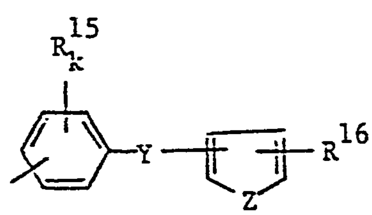

XII XIII

worin $R^{15}$ jeweils für ein Halogenatom oder eine Alkyl-, Cycloalkyl-, Alkenyl-, Cycloalkenyl-, Alkoxy-, Cycloalkoxy-, Alkenoxy-, Cycloalkenoxy-, Carbalkoxy-, Carbocycloalkoxy-, Carbalkenoxy- oder Carbocycloalkenoxygruppe steht, wobei diese organischen Gruppen 1 bis 9 Kohlenstoffatome aufweisen, oder eine Nitrogruppe oder eine Carbon-, Sulfon- oder Phosphorsäuregruppe in Salzform darstellt, k die oben angegebene Bedeutung hat, $R^{16}$ für eine Valenzbindung oder ein Wasser-

stoffatom und Y für eine Gruppierung der Formel

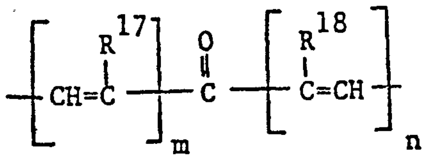

oder

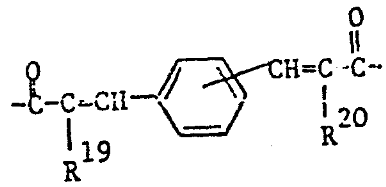

XIV

XV

oder

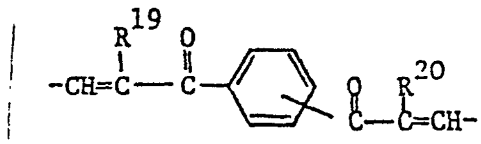

XVI

stehen, wobei $R^{17}$ und $R^{18}$ unabhängig voneinander je ein Wasserstoffatom, eine Alkylgruppe mit z.B. 1 bis 4 Kohlenstoffatomen oder eine Arylgruppe, vorzugsweise eine einkernige Gruppe wie eine Phenylgruppe bedeuten, oder $R^{17}$ und $R^{18}$ zusammen eine Polymethylenkette mit 2 bis 4 Methylengruppen darstellen, $R^{19}$ und $R^{20}$ je für ein Wasserstoffatom, eine Alkylgruppe mit z.B. 1 bis 4 Kohlenstoffatomen oder eine Arylgruppe stehen, bei der es sich vorzugsweise um eine einkernige Gruppe wie eine Phenylgruppe handelt, m und n je null, 1 oder 2 sind, vorausgesetzt dass sie nicht beide null sind, und Z ein Sauerstoff- oder Schwefelatom bedeutet.

Geeignete 3-substituierte Acrylate enthalten Gruppen der allgemeinen Formel

$$R^{21}CH=C(R^{1})COO- \qquad XVII$$

worin $R^{21}$ für eine aliphatische oder einkernige aromatische, araliphatische oder heterocyclische Gruppe steht, die wie schon angegeben äthylenisch oder aromatisch ungesättigt und mit der gezeigten Aethylendoppelbindung konjugiert ist, wie eine Phenyl-, 2-Furyl-, 2- oder 3-Pyridyl-, Prop-2-enyl- oder Styrylgruppe, und $R^1$ die oben angegebene Bedeutung hat.

Spezielle Beispiele dafür sind die Disorbinate von Polyoxyalkylenglykolen, Polyvinylcinnamat sowie Epoxidharz-zimtsäureprodukte.

Oniumsalze, die in Kombination mit einem Epoxidharz oder sonstigen kationisch polymerisierbaren Substanzen photopolymerisierbare Gemische ergeben, sind in den U.S. Patentschriften Nr. 4 058 400 und 4 058 401 beschrieben. Geeignete, für den gleichen Zweck verwendbare Sulfoxoniumsalze wurden in der U.S. Patentschrift Nr. 4 299 938 sowie in den europäischen Patentanmeldungen Nr. 35 969 und 44 274 offenbart.

Geeignete, bei dem erfindungsgemässen Verfahren verwendbare doppelfunktionelle Materialien enthalten eine oder mehrere Acrylestergruppen, die unter den zur Polymerisation anärob härtender Materialien angewandten anäroben Bedingungen polymerisieren, sowie eine oder mehrere, wie oben beschriebene Gruppen, die bei Bestrahlung oder bei Aktivierung durch ein bestrahltes Molekül polymerisieren. Bevorzugt werden solche Materialien, die eine oder mehrere Acrylestergruppen und eine oder mehrere Gruppen der Formel X, XII oder XIII oder eine oder mehrere Epoxidgruppen enthalten. Doppelfunktionelle Materialien lassen sich dadurch herstellen, dass man eine oder mehrere Acrylestergruppen in eine Verbindung einführt, die bereits eine oder mehrere photopolymerisierbare Gruppen sowie eine oder mehrere reaktionsfähige Gruppen wie Carbonsäure-, phenolische oder alkoholische Hydroxyl-, Epoxid- oder Imidogruppen enthält.

Beispiele für eine photopolymerisierbare Gruppe sowie eine Carbonsäuregruppe enthaltende Verbindungsklassen sind azidoaromatische Säuren, carboxylsubstituierte Stilbenderivate wie Stilbenbenzimidazole, Stilbenbenzoxazole, Stilbenbenztriazole, Stilbennaphthotriazole und Stilbenbenzthiazole, carboxylhaltige Maleinimide, wobei die beiden Aethylenkohlenstoffatome des Maleinimidrings durch Alkylgruppen mit 1 bis 4 Kohlenstoffatomen, Phenylgruppen oder Chloratome substituiert sind, sowie in 3-Stellung durch äthylenisch oder aromatisch ungesättigte, mit der Aethylenbindung in der 2,3-Stellung konjugierte Gruppen substituierte Acrylsäuren.

Eine photopolymerisierbare Gruppe und ebenfalls eine phenolische Hydroxylgruppe enthaltende Verbindungsklassen sind beispielsweise hydroxylsubstituierte Chalkone und hydroxyphenylsubstituierte Propenone und Pentadienone. Beispiele für eine photopolymerisierbare Gruppe und auch eine

alkoholische Hydroxylgruppe enthaltende Verbindungsklassen sind hydroxylsubstituierte Maleinimide und hydroxylsubstituierte Pyridinone. Solche hydroxylgruppenhaltige Verbindungen kann man direkt mit einer Acrylsäure oder einem acylierenden Derivat von dieser umsetzen, oder sie können zunächst in ihre Glycidyläther überführt und dann mit Acrylsäure oder einem hydroxylsubstituierten Ester davon zur Reaktion gebracht werden.

Eine photopolymerisierbare Gruppe und eine Imidogruppe enthaltende Verbindungsklassen sind beispielsweise disubstituierte Maleinimide, in denen die beiden Aethylenkohlenstoffatome des Maleinimidrings wie oben angegeben substituiert sind.

Geeignete azidoaromatische Säuren sind 4-Azidobenzoesäure und weitere Verbindungen der Formel

$N_3$-Ar-COOH XVIII

worin Ar die oben angegebene Bedeutung hat.

Als carboxylhaltige Stilbenderivate eignen sich 4-(1-Methylbenzimidazol-2-yl)-stilben-4'-carbonsäure, 4-(2H-Naphtho[1,2-d]triazol-2-yl)-stilben-4'-carbonsäure sowie weitere Verbindungen der allgemeinen Formel

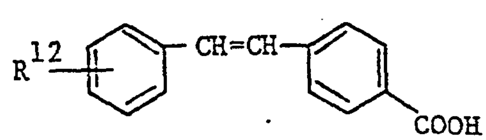

XIX

worin $R^{12}$ die oben angegebene Bedeutung hat.

Als carboxylhaltige Maleinimide eignen sich N-(Carboxyphenyl)-dimethylmaleinimid und weitere Verbindungen der allgemeinen Formel

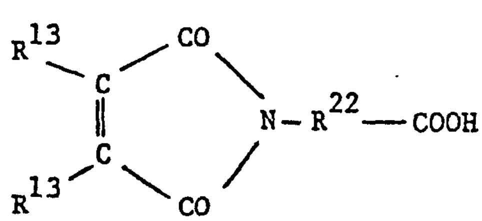

XX

worin $R^{13}$ jeweils die oben angegebene Bedeutung hat und $R^{22}$ für den bis zu 14 Kohlenstoffatome aufweisenden Rest einer aromatischen, aliphatischen oder cycloaliphatischen Amino-

BAD ORIGINAL

carbonsäure nach Wegnahme einer primären Aminogruppe und einer Carbonsäuregruppe steht.

Als hydroxylsubstituierte Chalkone und hydroxyphenylsubstituierte Propenone und Pentadienone eignen sich 1-(4-Hydroxyphenyl)-3-oxo-3-phenylpropen-1, 1-(4-Hydroxyphenyl)-1-oxo-3-phenylpropen-2, 1-(2-Furyl)-3-oxo-3-(4-hydroxyphenyl)-propen-1 und weitere Verbindungen der allgemeinen Formel

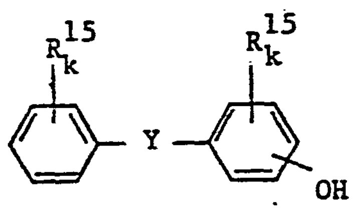

oder

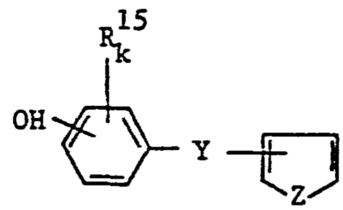

XXI XXII

worin $R^{15}$, k, Y und Z je die oben angegebenen Bedeutungen haben.

Geeignete hydroxylsubstituierte Maleinimide und hydroxylsubstituierte Pyridinone sind N-(2-Hydroxyäthyl)-dimethylmaleinimid, 4,6-Dimethyl-1-(2-hydroxyäthyl)-pyridinon-2 sowie weitere Verbindungen der allgemeinen Formel

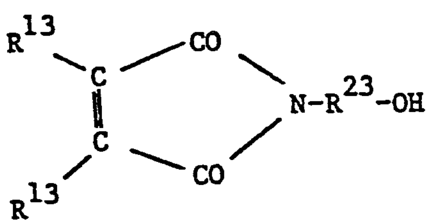

oder

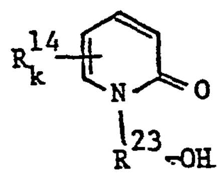

XXIII XXIV

worin $R^{13}$, $R^{14}$ und k je die oben angebenen Bedeutungen haben und $R^{23}$ für den nicht mehr als 8 Kohlenstoffatome aufweisenden Rest eines aliphatischen oder cycloaliphatischen Aminoalkohols nach Wegnahme einer Aminogruppe und einer alkoholischen Hydroxylgruppe steht.

Geeignete Imide sind Dimethylmaleinimid und weitere Verbindungen der allgemeinen Formel

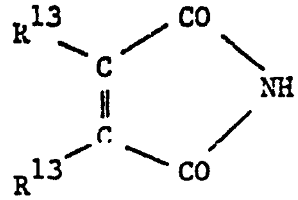

XXV

worin $R^{13}$ jeweils die oben angegebene Bedeutung hat.

Geeignete 3-substituierte Acrylsäuren entsprechen der Formel

$$R^{21}CH=C(R^1)COOH \qquad XXVI$$

worin $R^1$ und $R^{21}$ die oben angegebenen Bedeutungen haben.

Die Acrylgruppe bzw. -gruppen lassen sich in solche Verbindungen nach bekannten Methoden einführen, beispielsweise durch Veresterung unter Verwendung einer Acrylsäure oder eines reaktionsfähigen Acrylsäurederivats bzw. eines acryloylgruppenhaltigen Alkohols wie Hydroxyäthylmethacrylat.

Weitere in Gegenwart eines strahlungsempfindlichen aromatischen Oniumsalzes als doppelfunktionelle Materialien verwendbare Substanzen sind solche, die sowohl eine Epoxidgruppe als auch eine Acrylestergruppe enthalten, vorzugsweise solche der Formeln

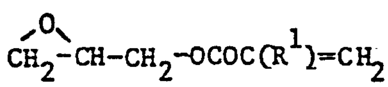

XXVII,

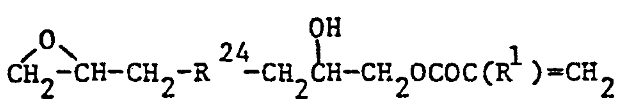

XXVIII

und

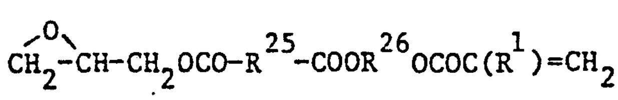

XXIX

worin $R^1$ die oben angegebene Bedeutung hat, $R^{24}$ für den Rest einer Polyglycidylverbindung nach Wegnahme von zwei Glycidylgruppen, $R^{25}$ für den Rest einer Polycarbonsäure nach Wegnahme von zwei Carbonsäuregruppen und $R^{26}$ für eine Alkylenkette mit 1 bis 6 Kohlenstoffatomen stehen.

Als solche Reste $R^{24}$ eignen sich unter anderem zweiwertige Phenolreste, insbesondere Bisphenolreste, nach Weg-

nahme der beiden phenolischen Wasserstoffatome, Glykolreste nach Wegnahme der beiden alkoholischen Wasserstoffatome und Hydantoinreste nach Wegnahme der beiden Amidwasserstoffatome. Als Reste $R^{25}$ eignen sich gesättigte oder ungesättigte, aliphatische oder aromatische Dicarbonsäurereste sowie aromatische Tri- oder Tetracarbonsäurereste nach Entfernung von zwei Carbonsäuregruppen, wie Bernstein-, Malon-, Malein-, Phthal-, Trimellith- und Pyromellithsäurereste. Geeignete Alkylengruppen $R^{26}$ sind Aethylen-, Propylen- und Butylengruppen.

Es ist ersichtlich, dass diese Verbindungen unter die Definition der schon oben zur Verwendung als anärob polymerisierbare Materialien vorgeschlagenen Verbindungen fallen. In Abwesenheit eines strahlungsempfindlichen kationischen Katalysators wie eines aromatischen Oniumsalzes sind die Epoxidgruppen in solchen Verbindungen nicht photopolymerisierbar.

Geeignete Verbindungen der Formeln XXVII bis XXIX lassen sich dadurch herstellen, dass man eine Gruppe $-OCOC(R^1)=CH_2$ in eine bereits eine oder mehrere 1,2-Epoxidgruppen enthaltende Verbindungen bzw. umgekehrt eine oder mehrere 1,2-Epoxidgruppen in eine bereits eine oder mehrere Gruppen der Formel $-OCOC(R^1)=CH_2$ enthaltende Verbindung einführt.

Eine bequeme Methode zur Einführung einer Gruppe $-OCOC(R^1)=CH_2$ in eine bereits Epoxidgruppen enthaltende Verbindung zur Herstellung von beispielsweise einer Verbindung der Formel XXVIII besteht darin, dass man zumindest ein Diepoxid mit einem stöchiometrischen Unterschuss, bezogen auf den Epoxidgruppengehalt, einer sowohl eine Gruppe $-OCOC(R^1)=CH_2$ als auch eine mit einer 1,2-Epoxidgruppe reaktionsfähigen Gruppe wie eine Carbonsäure-, phenolische oder alkoholische Hydroxyl- oder Imidogruppe enthaltenden Verbindung, umsetzt, um mindestens eine Acrylestergruppe in das Molekül einzuführen. Zu geeigneten Polyepoxiden gehören die Polyglycidylester von Polycarbonsäuren wie Bernsteinsäure, die Polyglycidyläther von mehrwertigen Alkoholen wie Butan-1,4-diol und mehrwertigen Phenolen wie 2,2-Bis-(4-hydroxyphenyl)-propan und Poly-

BAD ORIGINAL

(N-glycidyl)-verbindungen wie N,N'-Diglycidylhydantoinen. Es versteht sich, dass diese Methode normalerweise keine 100%ige Ausbeute an im gleichen Molekül sowohl eine 1,2-Epoxidgruppe als auch eine Acrylgruppe enthaltendem Material ergeben wird. Das verbleibende Material im Produkt stellt ein Gemisch unveränderten Ausgangsmaterials mit der ursprünglichen Anzahl Epoxidgruppen mit Material, in dem sämtliche Epoxidgruppen durch Acrylestergruppen ersetzt worden sind, dar. Da solche Gemische jedoch im vorliegenden Verfahren erfolgreich eingesetzt werden können, hat die Tatsache, dass das Reaktionsprodukt ein Gemisch ist, keine weiteren Folgen.

Bei einer zweckmässigen Methode zur Einführung einer oder mehrerer Epoxidgruppen in eine Verbindung mit mindestens einer Gruppe $-OCOC(R^1)=CH_2$ zur Herstellung von beispielsweise einer Verbindung der Formel XXVII verwendet man als erstere eine Verbindung, die ferner mindestens eine alkoholische Hydroxylgruppe oder Carboxylgruppe enthält, und behandelt diese in solcher Weise, dass die Gruppe(n) in 1,2-Epoxidgruppen umgewandelt wird bzw. werden, nach in der Epoxidharztechnik bekannten Methoden zur Umwandlung von Hydroxyl- oder Carboxylgruppen in Glycidyläther- oder -estergruppen. Beispielsweise lässt man die Verbindung in Gegenwart eines Chlorwasserstoffbindemittels (üblicherweise eine starke Base, z.B. NaOH) und vorzugsweise in Gegenwart eines Katalysators wie einer quartären Ammoniumverbindung, eines tertiären Amins, eines Uebergangsmetallsalzes, eines Thioäthers oder eines Sulfoniumsalzes mit Epichlorhydrin reagieren. Ueblicherweise setzt man einen Ueberschuss Epichlorhydrin über die theoretisch erforderliche Menge ein, wobei der Ueberschuss als Lösungsmittel für die Reaktion dient, welche normalerweise bei einer Temperatur von 30° bis 120°C, vorzugsweise 40 bis 65°C, und üblicherweise bei vermindertem Druck, zur Entfernung des gebildeten Reaktionswassers, durchgeführt wird.

Eine zweckmässige Methode zur Herstellung von Verbindungen wie solchen der Formel XXIX besteht darin, dass man eine hydroxylsubstituierte, eine Gruppe $-OCOC(R^1)=CH_2$ enthaltende Verbindung durch Umsetzung mit einem Polycarbon-

säureanhydrid in einen Partialester überführt. Die freie(n) Carbonsäuregruppe(n) kann bzw. können dann nach der oben beschriebenen Methode glycidyliert oder durch Behandlung mit einer zwei oder mehr Epoxidgruppen enthaltenden Verbindung verestert werden, üblicherweise bei 60 bis 120°C in Gegenwart einer starken Base und eines Katalysators wie einer quartären Ammoniumverbindung oder eines Uebergangsmetallsalzes.

Typische Verbindungen der Formeln XXVII bis XXIX sind Glycidylacrylat, Glycidylmethacrylat, 2-(4-Glycidyloxyphenyl)-2-(4-(3-acryloyloxy-2-hydroxypropoxy)-phenyl)-propan, 2-(4-(Glycidyloxyphenyl)-2-(4-(2-hydroxy-3-methacryloyloxy)-propoxy)-phenyl)-propan, 1-(2-Methacryloyloxyäthoxycarbonyl)-2,4- und -2,5-bis-(glycidyloxycarbonyl)-benzol, 1-(2-Acryloyloxyäthoxycarbonyl)-2,4- und -2,5-bis-(glycidyloxycarbonyl)-benzol, 2-Acryloyloxyäthoxy-glycidylsuccinat, 2-Methacryloyloxyäthoxy-glycidylsuccinat, 1-Glycidyl-3-(3-acryloyloxy-2-hydroxypropyl)-5,5-dimethylhydantoin, 1-Glycidyl-3-(2-hydroxy-3-methacryloyloxypropyl)-5,5-dimethylhydantoin, 1-Glycidyloxy-4-(3-acryloyloxy-2-hydroxypropoxy)-butan und 1-Glycidyloxy-4-(2-hydroxy-3-methacryloyloxypropoxy)-butan.

Die Photopolymerisation kann mittels Strahlung in Gegenwart eines Photosensibilisators wie 5-Nitroacenaphthen, 4-Nitroanilin, 2,4,7-Trinitro-9-fluorenon, 3-Methyl-1,3-diaza-1,6-benzanthron, Bis-(dialkylamino)-benzophenonen, insbesondere Michlers Keton, d.h. Bis-(p-dimethylamino)-benzophenon, und 2-Chlorthioxanthon erfolgen.

Der Photosensibilisator wird im allgemeinen zu 0,1 bis 20 Gew.-% und vorzugsweise 0,5 bis 15 Gew.-%, bezogen auf das Gewicht der photopolymerisierbaren Substanz, eingearbeitet.

Erfindungsgemäss verwendete Zusammensetzungen können ferner verschiedene Zusatzstoffe wie Inhibitoren zur Verhütung vorzeitiger Polymerisation, Verdünnungsmittel und Verdickungsmittel enthalten. Typische Inhibitoren sind Chinone oder Hydrochinone, die man in Mengen von 0,001 bis 0,1 Gew.-% bezogen auf die anärob härtende Komponente (a) einsetzen kann.

BAD ORIGINAL

Es wurde gefunden, dass die Einarbeitung einer Acrylsäure in die Zusammensetzung ein Produkt ergibt, das durch Behandlung mit wässrigem Alkali leicht entwickelt wird. Die bevorzugte Zusatzmenge für solche Säuren beträgt 0,5 bis 5,0 Gew.-%, berechnet auf das Gesamtgewicht der Zusammensetzung.

In Gegenwart genügender Mengen Sauerstoff sind die Zusammensetzungen über längere Zeiträume stabil, doch härten sie bei Sauerstoffausschluss. Sie werden deshalb am besten in Behältern gelagert, in denen ein ausreichender Luftraum besteht und/oder die luftdurchlässig sind.

Bei der Photopolymerisationsstufe verwendet man vorzugsweise aktinische Strahlung einer Wellenlänge von 200 bis 600 nm. Als Quellen für die aktinische Strahlung eignen sich unter anderem Kohlelichtbögen, Quecksilberdampflichtbögen, Leuchtröhren mit ultraviolettes Licht aussendenden Leuchtstoffen, Argon- und Xenonglimmlampen, Wolframlampen sowie photographische Flutlampen. Darunter sind Quecksilberdampflichtbögen, insbesondere Höhensonnen, fluoreszierende Höhensonnen und Metallhalogenidlampen am besten geeignet. Die zur Belichtung der verfestigten Schicht erforderliche Zeit hängt dabei von verschiedenen Faktoren ab, unter anderem beispielsweise dem jeweils verwendeten photopolymerisierbaren Material, dessen Anteil in der Zusammensetzung, der Art der Lichtquelle und deren Abstand von der Zusammensetzung. Ein Fachmann in Photopolymerisationsmethoden kann leicht die geeigneten Zeiten bestimmen.

Die erfindungsgemässen Zusammensetzungen können als Flüssigkeit auf ein Substrat wie Stahl, Aluminium, Kupfer, Cadmium, Zink, Papier, Kunststoffe oder Holz aufgebracht werden. Ist das Substrat kein Uebergangsmetall, so kann man es gewünschtenfalls durch Behandlung mit einem Gemisch aus einem Kondensationsprodukt eines Aldehyds mit einem primären oder sekundären Amin und einem schwefelhaltigem Radikalbeschleuniger oder durch Behandlung mit einer ein oxydierbares Uebergangsmetall enthaltenden Verbindung "aktivieren". Einzelheiten solcher Aktivierungsverfahren sind in der U.S. Patentschrift Nr. 3 616 040 angegeben.

Nach dem Aufbringen der Beschichtung auf das Substrat wird der Sauerstoff entfernt, zum Beispiel durch Evakuieren oder durch Verdrängung mit einem sauerstofffreien Gas wie feuchtem oder trockenem Stickstoff. Nachdem sich die Beschichtung anärob verfestigt hat, wird sie bestrahlt. Nach Belichtung eines Teils oder von Teilen der Beschichtung mit Strahlung wie durch eine Maske hindurch können die nicht gehärteten Stellen mit einem Lösungsmittel, wie Cyclohexanon, 2-Aethoxyäthanol, Toluol, Aceton und deren Gemischen bzw. wässrigen Lösungsmitteln wie verdünntem wässrigen Natriumcarbonat und Natriumhydroxyd, ausgewaschen werden. Die erfindungsgemässen Zusammensetzungen sind somit zur Herstellung von Druckplatten und gedruckten Schaltungen verwendbar. Methoden zur Herstellung von Druckplatten und gedruckten Schaltungen aus photopolymerisierbaren Zusammensetzungen sind wohlbekannt.

Die nachfolgenden Beispiele dienen der Erläuterung der Erfindung. Teile sind stets Gewichtsteile.

Die in den Beispielen verwendeten Materialien werden wie folgt hergestellt:

<u>1-(p-(2-Hydroxy-3-methacryloyloxypropoxy)-phenyl)-5-phenylpenta-1,4-dienon-3</u>

Man löst 1-Phenylbut-1-enon-3 (58,4 g) und p-Hydroxybenzaldehyd (48,8 g) in Aethanol (300 ml) und kühlt mittels Eisbad auf eine Temperatur unterhalb 15°C. Eine Lösung von Natriumhydroxyd (20 g) in Wasser (80 ml) wird im Verlauf von 2 Stunden dazugegeben, wobei man die Temperatur des Gemischs unterhalb 15°C hält. Diese Lösung wird dann mit verdünnter Salzsäure auf pH 7 neutralisiert. Ein öliger Feststoff scheidet sich aus, der abfiltriert und mit Toluol gewaschen wird, wobei man 30,5 g 1-(p-Hydroxyphenyl)-5-phenylpenta-1,4-dienon-3 erhält.

Dieses Produkt (25 g) gibt man im Verlauf von 30 Minuten zu einem 80°C heissen Gemisch aus Glycidylmethacrylat (14,3 g), Tetramethylammoniumchlorid (0,12 g) und 2,6-Ditertiär-butyl-4-methylphenol (0,08 g). Man erhitzt noch weitere 4 1/2 Stunden auf 80°C, wonach der Epoxidgehalt auf 0,24

BAD ORIGINAL

val/kg gefallen ist. Das Gemisch wird abgekühlt und liefert das gewünschte Produkt (39 g), das beim Stehen erstarrt.

Harzlösung I

Man vermischt 1,5-Bis-(4-glycidyloxyphenyl)-penta-1,4-dienon-3 (100 Teile) mit 2,2-Bis-(3,5-dibrom-4-hydroxyphenyl)-propan (38,2 Teile), 2,2-Bis-(4-hydroxyphenyl)-propan (27,3 Teile), Tetraäthylammoniumbromid (0,05 Teile) und 2-Hydroxyäthylmethacrylat (166 Teile). Dieses Gemisch wird 18 1/4 Stunden lang auf 100°C erhitzt, wonach sein Epoxidgehalt 0,44 val/kg und seine Viskosität 26 Pa.s bei 25°C beträgt. Dieses Gemisch stellt Harzlösung I dar.

Harzlösung II

Man erhitzt ein Gemisch aus 1,5-Bis-(4-glycidyloxyphenyl)-penta-1,4-dienon-3 (100 Teile), 2,6-Di-tert.-butyl-4-methylphenol (0,8 Teile) und 2-Hydroxyäthylmethacrylat (131 Teile) auf 100°C und versetzt im Verlauf von 20 Minuten portionsweise mit einem Gemisch aus 5,5-Dimethylhydantoin (30,5 Teile) und Tetramethylammoniumchlorid (0,4 Teile). Dann rührt man noch 15 Stunden bei 100°C, wonach das Gemisch einen Epoxidgehalt von 0,50 val/kg und eine Viskosität von 56,5 Pa.s bei 25°C aufweist. Dieses Gemisch stellt Harzlösung II dar.

Harzlösung III

Man vermischt 1,5-Bis-(4-glycidyloxyphenyl)-penta-1,4-dienon-3 (100 Teile) mit 2,2-Bis-(3,5-dibrom-4-hydroxyphenyl)-propan (38,2 Teile), 2,2-Bis-(4-hydroxyphenyl)-propan (27,3 Teile), Tetraäthylammoniumbromid (0,05 Teile) und 2-Methoxyäthylacrylat ( ). Man erhitzt 39 Stunden auf 100°C, wonach der Epoxidgehalt des Gemischs 0,53 val/kg und seine Viskosität 3,4 Pa.s beträgt. Dieses Gemisch stellt Harzlösung III dar.

Harzlösung IV

Man vermischt 1,5-Bis-(4-hydroxyphenyl)-penta-1,4-dienon-3 (58,5 Teile), 1,3-Diglycidyl-5-pentamethylenhydantoin (51,6 Teile), 2-Hydroxyäthylmethacrylat (110,1 Teile) und Tetraäthylammoniumbromid (0,3 Teile). Man erhitzt 9 Stunden auf 100°C, setzt dann eine weitere Menge Tetraäthylammoniumbromid

(0,3 g) dazu und erhitzt noch weitere 6 Stunden, wonach der Epoxidgehalt 0,14 val/kg beträgt. Durch Zugabe von Acrylsäure (2,5 Teile) in dieser Stufe und weitere 1 1/2 Stunden Erhitzen bei 100°C wird der Epoxidgehalt auf einen vernachlässigbaren Wert verringert. Dieses Gemisch stellt Harzlösung IV dar.

Harzlösung V

Man vermischt Benzophenontetracarbonsäuredianhydrid (629 Teile) mit 2-Hydroxyäthylmethacrylat (1 117 Teile), Tetramethylammoniumchlorid (3,2 Teile) und 2,6-Di-t-butyl-p-kresol (2,2 Teile). Man erhitzt 5 Stunden auf 80°C, wonach kein Anhydrid mehr vorhanden ist. Dieses Gemisch stellt Harzlösung V dar.

Harzlösung VI

Man vermischt Phenylglycidyläther (1 000 Teile, Epoxidgehalt 6.37 val/kg) mit Triphenylphosphin (3 Teile) und 2,6- Di-tert.-butyl-4-methylphenol (2 Teile) und erhitzt auf 100°C. Im Verlauf von 1 Stunde wird Methacrylsäure (547,8 Teile) dazugegeben, wobei man die Temperatur bei 100°C hält, und noch weitere 6 Stunden erhitzt. Nach Abkühlen beträgt der Epoxidgehalt dieses Produkts 0,84 val/kg und seine Viskosität 0.0425 Pa.s bei 25°C. Durch Auflösen von Polyvinylcinnamat (10 Teile) im Produkt (10 Teile) erhält man Harzlösung VI.

Harz VII

Man erhitzt ein Gemisch aus einem Epoxinovolakharz (100 Teile) mit einem Epoxidgehalt von 5,61 val/kg, welches einen aus einem Phenol/Formaldehydnovolak vom Durchschnittsmolekulargewicht 420 hergestellten Polyglycidyläther darstellt, 2,6-Di-t-butyl-p-kresol (0,2 Teile) und Chrom-IIItrisoctanoat (0,1 Teile) auf 120°C und versetzt im Verlauf 1 Stunde mit Zimtsäure (83 Teile). Man erhitzt noch weitere 3 1/2 Stunden auf 120°C und lässt dann abkühlen. Das Produkt wird bei Raumtemperatur fest und besitzt einen Epoxidgehalt von 0,16 val/kg.

Harz VIII - 2-Acryloyloxyäthoxycarbonamidobenzol

Dieses wird durch tropfenweise Zugabe von Hydroxy-

äthylacrylat (60 Teile) unter Rühren zu einem Gemisch aus Phenylisocyanat (59 Teile) und Dibutylzinn-dilaurat (0,2 Teile) und nachfolgendes Erhitzen auf 70°C bis zur vollständigen Reaktion des Isocyanats hergestellt.

Harz IX

Man erhitzt ein Gemisch aus einem Epoxinovolakharz (9,9 Teile) mit einem Epoxidgehalt von 5,61 val/kg, welches einen aus einem Phenol/Formaldehydnovolak vom Durchschnittsmolekulargewicht 420 hergestellten Polyglycidyläther darstellt, 2,2-Bis-(4-hydroxyphenyl)-propan (2,3 Teile), 4-Azidobenzoesäure (4,8 Teile), 2,6-Di-t-butyl-p-kresol (0,14 Teile), Tetramethylammoniumchlorid (0,05 Teile) und Cyclohexanon (40 Teile) unter Rühren 5 Stunden auf 120°C, wonach der Epoxidgehalt auf einen vernachlässigbaren Wert verringert ist. Das Cyclohexanon wird dann durch Destillation bei vermindertem Druck entfernt.

BEISPIEL 1

Man bringt eine N-(2-Acryloyloxyäthyl)-dimethylmaleinimid (10 Teile), 1,1,1-Trimethylolpropan-trismethacrylat (2 Teile), Cumolhydroperoxyd (0,3 Teile), N,N-Dimethyl-p-toluidin (0,01 Teil), Benzoesäuresulfimid (0,02 Teile) und 2-Chlorthioxanthon (0,2 Teile) enthaltende Zusammensetzung durch Schleuderbeschichtung so auf eine Kupferplatte auf, dass eine 18 µm dicke Beschichtung verbleibt. Die Platte wird in einen luftdichten Behälter gelegt, den man 30 Minuten bei Raumtemperatur mit Stickstoff ausspült, wonach die Beschichtung sich zu einem klebfreien Film verfestigt hat.

Der Film wird 15 Minuten durch ein Negativ hindurch mit einer 5 000 W Metallhalogenidlampe in 750 mm Abstand bestrahlt. Entwicklung in Cyclohexanon ergibt eine gute Abbildung auf der Platte.

BEISPIEL 2

Man stellt eine 1-(p-(2-Hydroxy-3-methacryloyloxypropoxy)-phenyl)-5-phenylpenta-1,4-dienon-3 (10,0 Teile), Trimethylolpropan-trismethacrylat (3,0 Teile), Cumolhydroperoxyd (0,3 Teile), N,N-Dimethyl-p-toluidin (0,01 Teil), Benzoesäuresulfimid (0,02 Teile) und Benzildimethylketal (0,2

Teile) enthaltende Zusammensetzung her, wobei die letztgenannte Verbindung den Zweck hat, die Photopolymerisation gegebenenfalls noch nicht anärob polymerisierten Trismethacrylats zu katalysieren. Diese flüssige Zusammensetzung wird durch Schleuderbeschichtung auf eine kupferkaschierte Laminatfolie aufgebracht, wobei eine 22 µm dicke Beschichtung verbleibt. Die Platte legt man in einen luftdichten Behälter und spült mit Stickstoff, bis der Sauerstoffgehalt der Behälteratmosphäre unterhalb 0,5 Vol.-% liegt. Nach 30 Minuten bei Raumtemperatur wird die Platte herausgenommen; die flüssige Zusammensetzung hat sich zu einem klebfreien Film verfestigt.

Der Film wird 15 Minuten durch ein Negativ hindurch mit einer 5 000 W Metallhalogenidlampe in 750 mm Abstand bestrahlt. Entwicklung in Toluol ergibt eine gute Abbildung auf der Platte.

BEISPIEL 3

Man stellt eine N-(2-Acryloyloxyäthyl)-dimethylmaleinimid (9,0 Teile), Cumolhydroperoxyd (0,3 Teile), Methacrylsäure (1,0 Teil), N,N-Dimethyl-p-toluidin (0,01 Teil), Benzoesäuresulfimid (0,02 Teile), 2-Chlorthioxanthon (0,2 Teile) und Benzildimethylketal (0,2 Teile) enthaltende Zusammensetzung her. Diese wird auf ein in einer Stickstoffatmosphäre gehaltenes kupferkaschiertes Laminat aufgetragen und wie in Beispiel 2 beschrieben bestrahlt. Entwicklung erfolgt in 2%iger wässriger Natronlauge, wobei man eine gute Abbildung erhält.

BEISPIEL 4

Man stellt eine N-(2-Methacryloyloxyäthyl)-dimethylmaleinimid (9,0 Teile), Tetrahydrofurfurylmethacrylat (1,0 Teil), Cumolhydroperoxyd (0,3 Teile), N,N-Dimethyl-p-toluidin (0,01 Teile), Benzoesäuresulfimid (0,02 Teile), 2-Chlorthioxanthon (0,2 Teile) und Benzildimethylketal (0,2 Teile) enthaltende Zusammensetzung her. Diese Zusammensetzung wird wie in Beispiel 2 beschrieben auf ein kupferkaschiertes Laminat aufgebracht. Die nasse Beschichtung wird dann mit einem silikonbeschichteten Trennpapier bedeckt, und zwischen dem

Laminat und dem Trennpapier wird ein Vakuum (67 Torr) angelegt. Nach 30 Minuten wird das Vakuum aufgehoben und das Trennpapier abgenommen. Die nunmehr trockene und klebfreie Beschichtung wird dann wie in Beispiel 2 beschrieben durch ein Negativ hindurch bestrahlt, und durch Behandlung mit Toluol wird eine gute Abbildung entwickelt.

BEISPIEL 5

Man stellt eine N-(2-Methacryloyloxyäthyl)-dimethylmaleinimid (9,0 Teile), Tetrahydrofurfurylmethacrylat (1,0 Teil), Methacrylsäure (1,0 Teil), Benzildimethylketal (0,1 Teile), 2-Chlorthioxanthon (0,1 Teile), Cumolhydroperoxyd (0,7 Teile) und das aus Triäthylentetramin (1 Mol) und Isobutylmethylketon (2 Mol) gebildete Ketimin (2,0 Teile) enthaltende Zusammensetzung her. Diese Zusammensetzung wird wie in Beispiel 2 beschrieben auf ein kupferkaschiertes Laminat aufgetragen, welches dann in eine luftdichte Kammer gelegt wird. Die Luft wird durch mittels Durchleiten durch 40° warmes Wasser befeuchteten Stickstoff unter Atmosphärendruck verdrängt.

Nach Herausnehmen aus der Stickstoffatmosphäre nach 10 Minuten ist die Beschichtung trocken und klebfrei. Sie wird durch ein Negativ hindurch 10 Minuten mit einer 5 000 W Metallhalogenidlampe in 750 mm Abstand bestrahlt. Durch Behandlung mit 2%iger wässriger Natronlauge wird eine gute Abbildung entwickelt.

BEISPIEL 6

Man stellt eine Harzlösung I (10,0 Teile), Cumolhydroperoxyd (0,3 Teile), N,N-Dimethyl-p-toluidin (0,01 Teile), Benzoesäuresulfimid (0,02 Teile) und Benzildimethylketal (0,2 Teile) enthaltende Zusammensetzung her. Diese wird so auf ein kupferkaschiertes Laminat aufgebracht, dass eine 6 µm dicke Beschichtung verbleibt, und das Laminat wird 5 Minuten lang in einer Stickstoffatmosphäre belassen, wonach die Beschichtung klebfrei ist. Sie wird im Vakuum 10 Sekunden lang durch ein Negativ hindurch mit einer 5 000 W Metallhalogenidlampe in 750 mm Abstand bestrahlt. Entwicklung in Cyclohexanon ergibt eine gute Abbildung auf der Platte.

BEISPIEL 7

Man stellt eine Harzlösung II (10 Teile), Cumolhydroperoxyd (0,3 Teile), N,N-Dimethyl-p-toluidin (0,01 Teil) und Benzildimethylketal (0,2 Teile) enthaltende Zusammensetzung her. Diese wird so auf ein kupferkaschiertes Laminat aufgebracht, dass eine 8 µm dicke Beschichtung verbleibt. Das Laminat wird 10 Minuten in einer Stickstoffatmosphäre belassen, wonach die Beschichtung klebfrei ist. Sie wird im Vakuum 10 Sekunden durch ein Negativ hindurch mit einer 5 000 W Metallhalogenidlampe in 750 mm Abstand bestrahlt. Entwicklung in Cyclohexanon ergibt eine gute Abbildung auf der Platte.

BEISPIEL 8

Man stellt eine 2,2-Bis-(4-(2-hydroxy-3-methacryloyloxypropoxy)-phenyl)-propan (60 Teile), Tripropylenglykoldiacrylat (20 Teile), 2-Hydroxyäthylmethacrylat (20 Teile), Cumolhydroperoxyd (3 Teile), Benzoesäuresulfimid (0,2 Teile), N,N-Dimethyl-p-toluidin (0,1 Teile) und Benzildimethylketal (2 Teile) enthaltende Zusammensetzung her. Diese wird nach der Ziehstabmethode so auf ein kupferkaschiertes Laminat aufgebracht, dass sich eine Beschichtung von 25-28 µm ergibt. Das Laminat wird dann 15 Minuten in einer Stickstoffatmosphäre belassen, wonach die Beschichtung klebfrei ist. Sie wird 60 Sekunden im Vakuum durch ein Negativ hindurch mit einer 5 000 W Metallhalogenidlampe im 750 mm Abstand bestrahlt. Entwicklung in Aceton ergibt eine gute Abbildung auf der Platte.

BEISPIEL 9

Man stellt eine Harzlösung III (10 Teile), Cumolhydroperoxyd (0,3 Teile), N,N-Dimethyl-p-toluidin (0,02 Teile) und Benzoesäuresulfimid (0,04 Teile) enthaltende Zusammensetzung her. Diese wird auf ein kupferkaschiertes Laminat zu einer 10-14 µm dicken Beschichtung aufgebracht, welche man dann 20 Minuten in einer Stickstoffatmosphäre belässt, wobei sich eine klebfreie Beschichtung ergibt. Diese wird im Vakuum 60 Sekunden durch ein Negativ hindurch mit einer 5 000 W Metallhalogenidlampe in 750 mm Abstand bestrahlt. Entwick-

lung in Butyldiglykol ergibt eine gute Abbildung.

BEISPIEL 10

Man stellt eine Harzlösung IV (9 Teile), Harzlösung V (1 Teil), Cumolhydroperoxyd (0,3 Teile), N,N-Dimethyl-p-toluidin (0,01 Teile) und Benzoesäuresulfimid (0,02 Teile) enthaltende Zusammensetzung her. Diese wird auf ein kupferkaschiertes Laminat zu einer 18-20 µm dicken Beschichtung aufgebracht, und das Laminat wird 15 Minuten in eine Stickstoffatmosphäre gelegt, wonach die Beschichtung klebfrei ist. Sie wird im Vakuum 30 Sekunden durch ein Negativ hindurch mit einer 5 000 W Metallhalogenidlampe in 750 mm Abstand bestrahlt. Entwicklung durch Bürsten mit 2%iger wässriger Natriumcarbonatlösung ergibt eine Abbildung.

BEISPIEL 11

Man stellt eine Harzlösung I (100 Teile), p-Toluolsulfonsäurehydrazid (1 Teil), Benzoesäuresulfimid (1 Teil) und N,N-Dimethyl-p-toluidin-N-oxyd (1 Teil) enthaltende Zusammensetzung her. Diese wird auf ein zuvor gesäubertes kupferkaschiertes Laminat aufgetragen und 5 Minuten in eine Stickstoffatmosphäre bei 45°C gelegt, wobei eine 25 µm dicke, klebfreie Beschichtung entsteht. Diese wird 60 Sekunden durch ein Negativ hindurch mit einer 5 000 W Metallhalogenidlampe in 750 mm Abstand bestrahlt. Beim Entwickeln in Benzylalkohol entsteht eine gute Abbildung.

BEISPIEL 12

Harzlösung VI (20 Teile) wird mit Cumolhydroperoxyd (0,6 Teile), Benzoesäuresulfimid (0,04 Teile) und N,N-Dimethyl-p-toluidin (0,2 Teile) vermischt und so auf ein kupferkaschiertes Laminat aufgebracht, dass eine 6 µm dicke Beschichtung verbleibt. Dann legt man das Laminat zur Bildung einer klebfreien Beschichtung 15 Minuten lang in eine Stickstoffatmosphäre. Es wird im Vakuum 5 Minuten durch ein Negativ hindurch mit einer 5 000 W Metallhalogenidlampe in 750 mm Abstand bestrahlt. Entwicklung in Toluol/Aceton (9:1) ergibt eine gute Abbildung auf der Platte.

BEISPIEL 13

Man bringt ein Gemisch aus einem Epoxidnovolakharz

(50 Teile) mit einem Epoxidgehalt von 5,61 val/kg, welches einen aus einem Phenol/Formaldehydnovolak vom Molekulargewicht 420 hergestellten Polyglycidyläther darstellt, dem Tetraglycidyläther des 1,1,2,2-Tetrakis-(p-hydroxyphenyl)-äthans (50 Teile) mit einem Epoxidgehalt von 5,20 val/kg, 1,4-Butandiol-dimethacrylat (60 Teile), Cumolhydroperoxyd (7 Teile), Bis-(4-methylphenyl)-jodonium-hexafluorophosphat (2 Teile) und Beschleuniger NL 53A (1 Teil), einem von Akzo Chemie U.K. Ltd., Wandsworth, London S.W.18 erhältlichen und als Lösung von Kobaltmetall (10%) in Testbenzin beschriebenen Handelsprodukt, als 120-130 µm dicke Beschichtung auf ein kupferkaschiertes Laminat auf. Das beschichtete Laminat wird dann in eine luftdichte Kammer gelegt und die Luft durch auf eine Temperatur von 40°C vorerhitzten Stickstoff verdrängt. Nach einem Zeitraum von 5 Minuten ist die Beschichtung trokken und klebfrei. Sie wird dann 3 Minuten durch ein Negativ hindurch mit einer 5 000 W Metallhalogenidlampe in 750 mm Abstand bestrahlt. Beim Entwickeln in Aceton entsteht eine gute Abbildung.

## BEISPIEL 14

Man bringt ein Gemisch aus Harz VII (10 Teile), N,N-Diäthylaminoäthylacrylat (5 Teile), Cumolhydroperoxyd (0,6 Teile), Benzoesäuresulfimid (0,05 Teile) und Michlers Keton (0,2 Teile) als 15-17 µm dicke Beschichtung auf ein kupferkaschiertes Laminat auf. Das beschichtete Laminat wird in eine luftdichte Kammer gelegt und die Luft durch auf 40°C vorerhitzten Stickstoff verdrängt; nach 3 Minuten ist die Beschichtung trocken und klebfrei. Dann wird sie 3 Minuten durch ein Negativ hindurch unter einer 5 000 W Metallhalogenidlampe in 750 mm Abstand bestrahlt. In Aethanol entwikkelt sich eine gute Abbildung.

## BEISPIEL 15

Man bringt ein Gemisch aus Harz VII (6 Teile), Harz VIII (4 Teile), Cumolhydroperoxyd (0,5 Teile), Benzoesäuresulfimid (0,05 Teile) und Michlers Keton (0,2 Teile) als 8-10 µm dicke Beschichtung auf ein kupferkaschiertes Laminat auf. Das beschichtete Laminat wird in eine luftdichte Kammer

BAD ORIGINAL

gelegt und die Luft durch auf 40°C erhitzten Stickstoff verdrängt; nach 5 Minuten ergibt sich eine trockene klebfreie Beschichtung. Sie wird 1 Minute durch ein Negativ hindurch mit einer 5 000 W Metallhalogenidlampe in 750 mm Abstand bestrahlt. In Aethanol/Aceton (19:1) entwickelt sich eine gute Abbildung.

BEISPIEL 16

Man bringt ein Gemisch aus Harz IX (80 Teile), 2-Cyanäthylacrylat (20 Teile), Cumolhydroperoxyd (5 Teile) und Eisennaphthenat (6%ige Lösung in Testbenzin) (0,1 Teile) als 10-12 µm dicke Beschichtung auf ein kupferkaschiertes Laminat auf. Das beschichtete Laminat wird dann in eine luftdichte Kammer gelegt und die Luft durch auf 40°C erhitzten Stickstoff verdrängt; nach 10 Minuten ist die Beschichtung klebfrei. Sie wird dann 2 Minuten durch ein Negativ hindurch mit einer 5 000 W Metallhalogenidlampe in 750 mm Abstand bestrahlt. In Toluol entwickelt sich eine gute Abbildung.

## Ansprüche

1. Verfahren zur Erzeugung von Abbildungen, dadurch gekennzeichnet, dass man
(1) eine auf ein Substrat aufgebrachte Schicht einer (a) ein anärob polymerisierbares Material und (b) ein photopolymerisierbares Material enthaltenden flüssigen Zusammensetzung so lange in einer weitgehend sauerstofffreien Umgebung belässt, dass sich die flüssige Zusammensetzung verfestigt,
(2) die verfestigte Schicht bildweise mit aktinischer Strahlung belichtet und
(3) die Schicht zur Entfernung der bei (2) nicht mit aktinischer Strahlung belichteten Schichtstellen mit einem Entwickler behandelt.

2. Verfahren nach Anspruch 1, dadurch gekennzeichnet, dass das anärob polymerisierbare Material (a) aus (i) einem gegebenenfalls freie saure oder Aminogruppen enthaltenden Acrylsäureester (ii) einem Polymerisationsinitiator für (i) sowie gegebenenfalls (iii) einem Beschleuniger für die Polymerisation von (i) besteht.

3. Verfahren nach Anspruch 2, dadurch gekennzeichnet, dass als Ester (i) ein Ester eines ein- oder mehrwertigen Alkohols, einer Hydroxycarbonsäure, einer Hydroxysulfonsäure oder Hydroxyphosphorsäure oder eines Hydroxyalkylamins oder Hydroxyalkylnitrils oder ein Acrylester-urethan oder Acrylester-ureid vorliegt.

4. Verfahren nach Anspruch 2 oder 3, dadurch gekennzeichnet, dass der Ester (i) nur eine Acrylestergruppe pro Molekül enthält.

5. Verfahren nach einem der Ansprüche 2 bis 4, dadurch gekennzeichnet, dass als Polymerisationsinitiator (ii) ein organisches Hydroperoxyd der Formel $R^{10}OOH$, worin $R^{10}$ einen einwertigen organischen Rest mit bis zu 18 Kohlenstoffatomen bedeutet, Wasserstoffperoxyd, ein organisches Peroxyd oder ein Gemisch eines organischen Aminoxyds und eines Sulfonsäurehydrazids vorliegt.

6. Verfahren nach einem der Ansprüche 1 bis 5, dadurch gekennzeichnet, dass das photopolymerisierbare Material (b)

mindestens zwei Gruppen wie Azido-, Cumarin-, Stilben-, Maleinimid-, Pyridinon-, Chalkon-, Propenon-, Pentadienon- oder in 3-Stellung durch eine äthylenisch oder aromatisch ungesättigte, mit ihren Aethylendoppelbindungen konjugierte Gruppe substituierte Acrylsäuregruppen enthält.

7. Verfahren nach einem der Ansprüche 1 bis 5, dadurch gekennzeichnet, dass das photopolymerisierbare Material (b) aus einem Epoxidharz, Phenolharz, Harnstoff/Formaldehydharz, cyclischen Aether, cyclischen Ester, cyclischen Sulfid, cyclischen Amin oder einer cyclischen Organosiliciumverbindung zusammen mit einem strahlungsempfindlichen aromatischen Oniumsalz besteht.

8. Verfahren nach einem der Ansprüche 1 bis 5, dadurch gekennzeichnet, dass die flüssige Zusammensetzung aus einer sowohl (a) als auch (b) darstellenden doppelfunktionellen Substanz mit sowohl anärob polymerisierbaren als auch photopolymerisierbaren Gruppen, gegebenenfalls zusammen mit einer anärob polymerisierbaren Substanz und/oder einer ausschliesslich photopolymerisierbaren Substanz besteht.

9. Verfahren nach Anspruch 8, dadurch gekennzeichnet, dass die doppelfunktionelle Substanz eine oder mehrere unter anäroben Bedingungen polymerisierende Acrylestergruppen sowie eine oder mehrere, wie in Anspruch 6 definierte lichtempfindliche Gruppen enthält.

10. Verfahren nach Anspruch 8, dadurch gekennzeichnet, dass die doppelfunktionelle Substanz eine oder mehrere unter anäroben Bedingungen polymerisierende Acrylestergruppen sowie eine oder mehrere, bei Aktivierung durch ein bestrahltes Molekül polymerisierende Gruppen enthält.